# EUROPEAN PATENT APPLICATION

(11) **EP 4 787 074 A1**
(43) Date of publication of application: **05.08.2026**
(21) Application number: 25155537.1
(22) Date of filing: 03.02.2025
(51) Int. Cl.: G03F 7/00, G03F 9/00

(54) **DIE-TO-WAFER BONDING PROCESS**

(71) Applicant: ASML Netherlands B.V., 5500 AH Veldhoven (NL)
(72) Inventor: VENUGOPALAN, Syam, Parayil, 5500 AH Veldhoven (NL); VROMEN, Joost, Anton, Frits, 5500 AH Veldhoven (NL); WANG, Sheng, 5500 AH Veldhoven (NL)
(74) Representative: ASML Netherlands B.V.

(57) **Abstract**

There is provided a method of determining a correction for at least one first substrate and/or a second substrate, the correction being defined across an exposure field on at least one first substrate, wherein the exposure field comprises multiple sub-field portions, wherein each sub-field portion is to be bonded to a second substrate to obtain a bonded substrate in a bonding process, the method comprising: obtaining a first component of parameter of interest data relating to a parameter of interest which is common to each sub-field portion of the said multiple sub-field portions; and determining the correction based on suppression of the first component for each sub-field portion of the multiple sub-field portions.

## Description

### FIELD OF THE INVENTION

The present invention relates to methods and apparatus for applying patterns to substrates, and in particular to a method of bonding semiconductor substrates in a lithographic manufacturing process.

### BACKGROUND OF THE INVENTION

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, parameters of the patterned substrate are measured. Parameters may include, for example, the overlay error between successive layers formed in or on the patterned substrate and critical linewidth (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258410a, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Process control methods are used in the manufacture of integrated devices to monitor and control the processes of application of a pattern on a substrate or measurement of such a pattern. Such process control techniques are typically performed to obtain corrections for control of the process. Subsequently, it is sometimes required (for certain devices) to bond substrates together. Bonding processes include die-to-die, die-to-wafer and wafer-to-wafer.

In die-to-wafer bonding, individual dies or chiplets are bonded to an acceptor wafer or substrate (i.e., a base patterned substrate).

It may be desirable to have improved methods of die-to-wafer bonding.

### SUMMARY OF THE INVENTION

There is provided a method of determining a correction for at least one first substrate and/or a second substrate, the correction being defined across an exposure field on at least one first substrate, wherein the exposure field comprises multiple sub-field portions, wherein each sub-field portion is to be bonded to a second substrate to obtain a bonded substrate in a bonding process, the method comprising: obtaining a first component of parameter of interest data relating to a parameter of interest which is common to each sub-field portion of the said multiple sub-field portions; and determining the correction based on suppression of the first component for each sub-field portion of the multiple sub-field portions.

In other aspects of the invention, there is provided a computer program operable to perform the method the first aspect and a substrate obtained by performing the method of the first aspect.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings in which:
- Figure 1 depicts a lithographic apparatus together with other apparatuses forming a production facility for semiconductor devices;
- Figure 2 (a) & (b) comprises a schematic diagram of a scatterometer for use in measuring targets;
- Figure 3 is a flow diagram describing a method of manufacturing integrated devices which utilizes wafer-to-wafer bonding;
- Figure 4 is a flow diagram describing a method of manufacturing integrated devices which utilizes wafer-to-wafer bonding;
- Figure 5 depicts a die-to-wafer bonding process; and
- Figure 6 depicts overlay error vectors for a field and corresponding subfields according to some embodiments.

### DETAILED DESCRIPTION OF THE INVENTION

Before describing embodiments of the invention in detail, it is instructive to present an example environment in which embodiments of the present invention may be implemented.

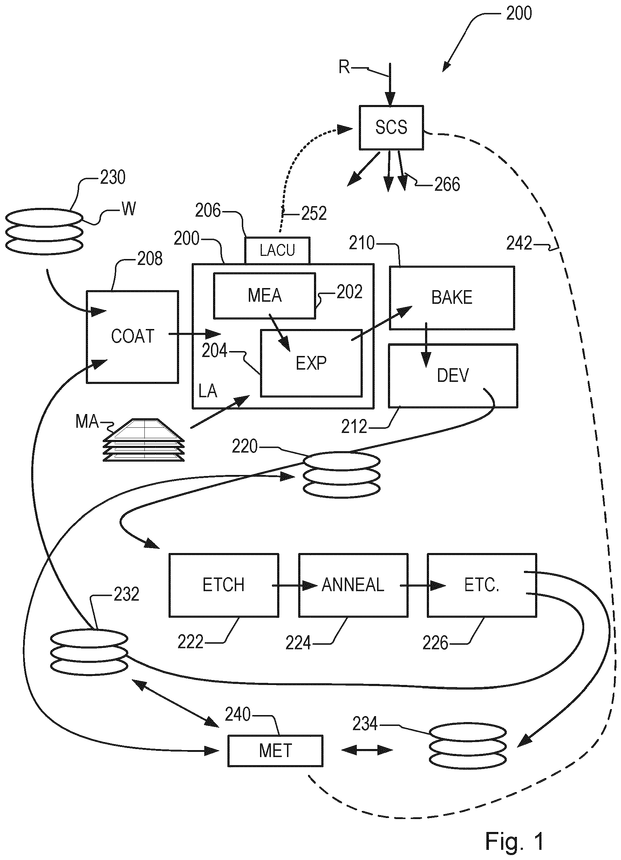

Figure 1 at 200 shows a lithographic apparatus LA as part of an industrial production facility implementing a high-volume, lithographic manufacturing process. In the present example, the manufacturing process is adapted for the manufacture of semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore, some layers may be exposed in an immersion type lithography tool, while others are exposed in a `dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly, a manufacturing facility in which litho cell LC is located also includes a metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

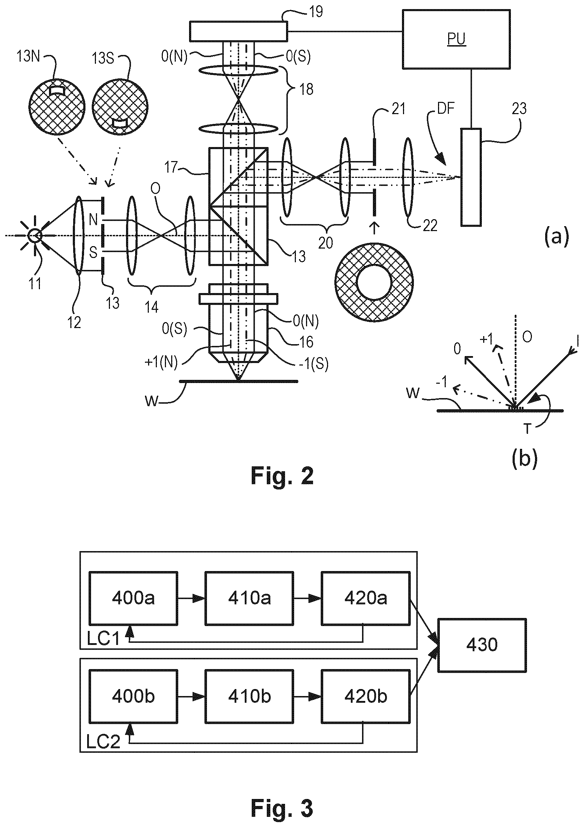

A metrology apparatus suitable for use in embodiments of the invention is shown in Figure 2(a). A target T and diffracted rays of measurement radiation used to illuminate the target are illustrated in more detail in Figure 2(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 2(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figures 2(a) and 2(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 2(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for many measurement purposes such as reconstruction used in methods described herein. The pupil plane image can also be used for focusing the metrology apparatus and/or normalizing intensity measurements of the first order beam.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 2 are purely examples. In another embodiment of the invention, on-axis illumination of the targets is used and an aperture stop with an off-axis aperture is used to pass substantially only one first order of diffracted light to the sensor. In yet other embodiments, 2^{nd}, 3^{rd} and higher order beams (not shown in Figure 2) can be used in measurements, instead of or in addition to the first order beams.

The target T may comprise a number of gratings, which may have differently biased overlay offsets in order to facilitate measurement of overlay between the layers in which the different parts of the composite gratings are formed. The gratings may also differ in their orientation, so as to diffract incoming radiation in X and Y directions. In one example, a target may comprise two X-direction gratings with biased overlay offsets +d and -d, and Y-direction gratings with biased overlay offsets +d and -d. Separate images of these gratings can be identified in the image captured by sensor 23. Once the separate images of the gratings have been identified, the intensities of those individual images can be measured, e.g., by averaging or summing selected pixel intensity values within the identified areas. Intensities and/or other properties of the images can be compared with one another. These results can be combined to measure different parameters of the lithographic process.

Figure 3 shows a device manufacturing arrangement for making bonded substrates (and therefore ICs based on bonded substrates) comprising a first manufacturing lithocell LC1 and a second manufacturing lithocell LC2. Within each lithocell is a pair of lithographic processing systems 400a, 400b and first metrology systems 410a, 410b. The lithographic processing system 400a, 400b, may comprise a full patterning system. Such a system may comprise, for example, an optical lithographic apparatus or scanner such as described in respect of Figure 1, a track tool, a deposition tool, an etch tool, any other apparatus used in the patterning process, or any combination selected therefrom. The systems may also each comprise a software application 420a, 420b in communication with its respective lithographic processing system 400a, 400b and metrology system 410a, 410b, so that results, designs, data, etc. of the lithographic processing system 400a, 400b and/or the metrology apparatus 410a, 410b may be stored and analyzed by the software application 420a, 420b at the same time or different times.

Once pairs of substrates or wafers are completed from each of lithocell LC1 and lithocell LC2, they may be bonded within a bonding tool 430 to obtain a bonded wafer. Bonding in this context is wafer-to-wafer bonding where whole wafers are aligned and bonded together such that individual dies on each wafer are aligned. The concept of wafer-to-wafer bonding is known and used in many IC manufacturing processes. The bonding tool 430 may comprise a bonding alignment device for aligning the wafers together for bonding. For example, the bonding tool 430 may perform pre-align using box-in-box marks provided to wafers (e.g., one box on each wafer), with visual inspection of marks used for alignment quality/ position control. Another method uses two imaging sensors (e.g., face to face) which are first calibrated together to find their relative positions; each sensor is then used to separately align a respective wafer to be bonded.

Lithocell LC1 and lithocell LC2 may be the same lithocell, different lithocells but comprising one or more shared tools and elements, or be completely different lithocells having completely different sets of apparatuses and tools, possibly even at different sites or fabs. For example, one or more of the tools or apparatuses of the lithographic processing systems 400a and 400b may comprise different tools or the same tools within each respective system. Similarly, metrology apparatuses 410a and 410b may be the same apparatus or different apparatuses. The software application 420a, 420b may be comprised within one or both of the respective lithographic processing systems 400a, 400b and/or one or both of the first metrology systems 410a, 410b, or elsewhere.

Once bonded, the bonded wafer may be subject to further lithographic patterning and processing (such as grinding). As such, alignment will be performed on the bonded wafer; e.g., for aligning the substrate and determining feed-forward corrections based on measured grid deformities. Also, post-exposure metrology, such as overlay metrology, may be performed on the bonded wafer after exposure; e.g., to determine feedback corrections for subsequent wafers.

As mentioned above, the lithographic processing system 400a, 400b may be configured to include the lithographic apparatus LA in Figure 1. The lithographic processing system 400a, 400b may be setup for executing the patterning aspect of the patterning process and optionally, may be configured to correct for deviations occurring within the lithographic processing system 400a, 400b or in one or more other processes or apparatuses in the patterning process. The lithographic processing system 400a, 400b may be able to apply a correction of an error (e.g., imaging error, focus error, dose error, etc.) by adjusting one or more modification apparatuses of the lithographic processing system 400a, 400b. That is, correction may be made by any manufacturing processing tool in the lithographic processing system 400a, 400b that can purposefully modify a patterning error.

For example, the correction of an error can be made by adjusting one or more modification apparatuses of the lithographic apparatus, e.g., by employing the adjustment mechanism AM to correct for or apply an optical aberration, by employing the adjuster AD to correct or modify an illumination intensity distribution, by employing the positioner PM of the patterning device support structure MT and/or the positioner PW of the wafer table WT to correct or modify the position of the patterning device support structure MT and or the wafer table WT respectively, etc. Where, for example, the lithographic processing system 400a, 400b comprises a track tool, correction of an error can be made by adjusting one or more modification apparatuses of the track tool, e.g., modifying a bake temperature of a bake tool of the track, modifying a development parameter of a development tool of the track, etc. Similarly, where, for example, the lithographic processing system 400a, 400b comprises an etch tool, correction of an error can be made by adjusting one or more modification apparatuses of the etch tool, e.g., modifying an etch parameter, such as etchant type, etchant rate, etc. Similarly, where, for example, the lithographic processing system 400a, 400b comprises a planarization tool, correction of an error can be made by adjusting one or more modification apparatuses of the planarization tool, e.g., modifying a planarization parameter. Similarly, where, for example, the lithographic processing system 400a, 400b comprises a deposition tool, correction of an error can be made by adjusting one or more modification apparatuses of the deposition tool, e.g., modifying a deposition parameter.

One or more modification apparatuses of the lithographic processing system 400a, 400b may be able to apply up to third order polynomial correction of errors (e.g., imaging error, focus error, dose error, etc.).

The metrology apparatus 410a, 410b may be configured to obtain measurements related to wafers printed with patterns by the lithographic processing system 400a, 400b. The metrology apparatus 410a, 410b may be configured to measure or determine one or more parameters (e.g., overlay error, dose, focus, CD, etc.) of the patterns printed by the lithographic processing system 400a, 400b. The metrology apparatus 410a, 410b may be a diffraction-based overlay metrology tool that can measure, e.g., overlay, critical dimension and/or other parameters. The metrology apparatus 410a, 410b may be an alignment apparatus used to measure relative position between two objects, such as between a patterning device and a wafer. The metrology apparatus 410a, 410b may be a level sensor to measure a position of a surface, e.g., a height and or rotational position of a wafer surface. The metrology apparatus 410a, 410b may be a plurality of metrology apparatuses including any combination of these devices.

The metrology apparatus 410a, 410b may measure and/or determine one or more values of one or more parameters (e.g., overlay error, CD, focus, dose, etc.) associated with an error in the patterning process. After the metrology apparatus 410a, 410b finishes the measurement or determination, the software application 420a, 420b creates modification information based on the measurement data (e.g., overlay error, CD, focus, dose, etc.). The software application 420a, 420b may evaluate the one or more values of the one or more parameters to determine if they are within a tolerance range. If not, the software application 420a, 420b determines modification information to correct an error reflected by the out of tolerance one or more values of the one or more parameters.

The software application 420a, 420b may use one or more mathematical models to determine error correctable by one or more modification apparatuses of the lithographic processing system 400a, 400b and to provide information for one or more parameters (e.g. modification information) of the one or more modification apparatuses of the lithographic processing system 400a, 400b, which one or more parameters enable configuration of the one or more modification apparatuses of the lithographic processing system 400a, 400b to correct (e.g., eliminate or reduce to within a tolerance range) the error. One or more of the mathematical models may define a set of basis functions that fit the data once parameterized. The one or more mathematical models may comprise a model configured to simulate correctable error for the lithographic processing system 400a, 400b. The model may specify a range of modifications that one or more of the modification apparatuses of the lithographic processing system 400a, 400b can make and determines correctable error within the range. That is, the range may specify an upper limit, a lower limit, and/or both on the amount of modifications that a particular modification apparatus of the lithographic processing system 400a, 400b can make.

Wafers may be bonded together which have incompatible or poorly optimized grids / shapes / dead die locations. For example, a first wafer may have a bowl shaped fingerprint with dead (or out of spec) dies being found at the edge and a second wafer may have a fingerprint with the inverse bowl shape such that dead dies are found near the center. Bonding of these wafers would be sub-optimal and wasteful compared to bonding wafers which have similar fingerprints. For bonding use cases a wafer may be paired with another wafer having a specific grid which is not necessarily matched to the grid of the current wafer.

Two methods will now be described which use wafer to wafer bonding of two or more wafers together to alleviate the above-mentioned problems. Such methods are described, for example in WO2021/175527A1 which is incorporated herein in its entirety by reference.

The methods comprise the following:
- Overlay feedforward correction of a bonding fingerprint induced by wafer bonding-process;
- Co-optimization of correction capabilities of scanner and wafer bonder control capabilities;

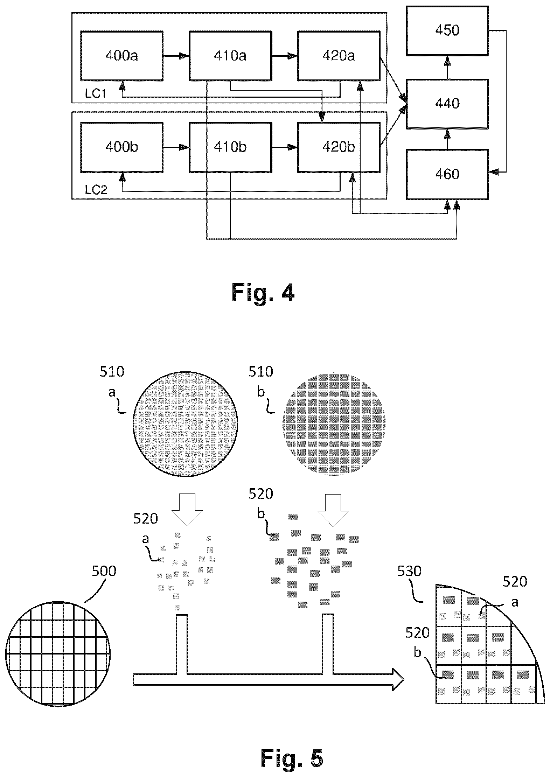

Figure 4 is a flow diagram which illustrates examples of these concepts in a single flow. However, it should be appreciated that both of these concepts can be implemented individually, and/or a method disclosed herein may comprise any one or more in any combination. Each concept will now be described individually. The flow diagram of Figure 4 is based upon that of Figure 3, and the same elements have the same labels and therefore will not be necessarily described further. As represented in Figure 4, the bonding apparatus 440 may have an associated bonding metrology tool 450 and bonding software application 460. As before, the bonding metrology tool 450 may be separate to the other metrology tools in the Figure, or it may be that the same metrology tool is represented by any two or all three of metrology tools 450, 410a, 410b. Similarly, the software application 460 may be the same (or run on the same apparatus) as one or both of software applications 420a, 420b, and may be run on any of the apparatuses represented in the Figure, and/or one or more separate processing apparatuses (not shown). Also note that the description below describes the bonding process as that bonding two wafers, or substrates. However, the concepts are equally applicable to bonding of more than two wafers, and as such any reference to terms such as "wafer pair" is to be understood to encompass sets of wafers greater than 2, which are to be bonded together.

As with Figure 3, lithocell FC1 and lithocell FC2 may be the same lithocell, different lithocells but comprising one or more shared tools and elements, or be completely different lithocells having completely different sets of apparatuses and tools, possibly even at different sites or fabs.

### Overlay feedforward correction of a bonding fingerprint induced by wafer bonding-process:

In this embodiment, it is proposed to measure the across substrate parameter (e.g., overlay) fingerprint after bonding, and using this fingerprint as an input for determining a correction or optimization for the bonding process for bonding of subsequent substartes. For example, after bonding of first and second wafers W1, W2, the fingerprint may be measured by metrology tool 450 and a correction or bonding optimization determined by software application 460 for the bonding third and fourth wafers W3 and W4. The correction may be determined based also on the individual fingerprints of each wafer (e.g., as measured by metrology tools 410a, 410b), such that software application deduces the bonding tool fingerprint contribution from the final bonded fingerprint and the two pre -bonding wafer fingerprints. The software application 460 can than actively actuate (e.g., via a correction and or optimization) the bonding tool 440 to optimize overlay for bonding the next wafer pair. Therefore, this concept may be represented in Figure 5, by the loop of elements 440, 450, 460 and the feedforward of data from metrology devices 410a, 410b to software application 460. [0054] In an embodiment, this method may be implemented within and by the APC control loop (e.g., loop LP2 of Figure 3). In an embodiment, the feedforward may be more comprehensive (e.g. via APC controller or otherwise) by taking a larger set of historic overlay data (pre-bonding and post-bonding fingerprints) into account; e.g., to prevent unstable control (for example, where the fingerprint data for an immediately preceding wafer pair is non-representative of the process generally).

### Co-optimization of correction capabilities of scanner and wafer bonder control capabilities:

Based on knowledge of the bonding tool fingerprint (e.g., using methods described in the previous embodiment) co-optimized corrections for the bonding tool fingerprint and one or both of the scanner fingerprints can be determined. The co-optimization may therefore determine co-optimized corrections for one or both exposure processes for each wafer pair to be bonded and for the bonding process, which together minimize overlay in the final bonded wafer. The co-optimization may also include corrections for other tools, such as an etching tool (which also induces its own fingerprint contribution). It can be appreciated, for example, that such a co-optimization method may actually worsen overlay (or even dies-in-spec) for one or both of the unbonded wafers, but in a manner which minimizes overlay across the bonded wafer and/or maximizes dies-in spec of the bonded wafer. Any co-optimization strategy may be used, including a die-in-spec co-optimization, a max-abs optimization, a least-squares co-optimization or any other suitable optimization. Co-optimization concepts are described, for example, in US2018/0252998 and WO2019/110261 both of which are incorporated herein by reference. Any of the co-optimization concepts described herein, but extended to the bonding process is envisaged in this embodiment.

For example, the co-optimization may comprise controlling the bonding tool and one or both scanner fingerprints such that the scanner corrections pre-correct for the bonding tool contribution to the overall bonded wafer overlay fingerprint. For example, such an optimization may comprise finding scanner and/or bonding tool (and or etch tool or other tool) corrections which minimize the difference between the second wafer (pre-bonding) fingerprint and the sum of the first wafer (pre -bonding) fingerprint and the bonding tool fingerprint (for a to-be-bonded wafer pair of said first wafer and second wafer). The co-optimization may also include co-optimizing a patterning device or reticle pattern (e.g., via a reticle patterning apparatus) used for patterning the first and or second wafer.

Such a co-optimization may be based on the correction capabilities of the relevant tools (e.g., scanners, bonding tool and/or etch tool), so as to distribute the correction across these tools to achieve lowest non-correctable error (NCE) for the parameter of interest (e.g., overlay); e.g., using a pattern fidelity control (PFC) type approach. This distribution between scanner and bonder (and possible other tool) correction capabilities can be based, not only on the type of correction capability (e.g., per spatial frequency, order, field), but also on the range of this correction capability. By way of specific example, by adding an offset to the scanner actuation, the resulting fingerprint can be brought closer to the center of the correction range of the bonding tool (or vice versa). Such concepts are described, for example in the aforementioned US2018/0252998.

In such an embodiment, the co-optimization may comprise (e.g., using one or more mathematical models) determining an error correctable by one or more apparatuses of the lithographic processing systems 400a, 400b and/or the bonding tool 440, and adding an offset (e.g., deliberate error) to one of the processes performed by one of these apparatuses (or to the reticle pattern itself). For example, the offset may result in a transformation of a non-correctable error by an apparatus of the lithographic processing systems 400a, 400b or bonding tool 440 to a correctable error by one or more other apparatuses of the lithographic processing systems 400a, 400b, the bonding tool 440 and/or the reticle pattern. As an example of such transformation, an error having an uncorrectable spatial resolution for a particular apparatus of one or both lithographic processing systems 400a, 400b and/or bonding tool 440 can be enabled for correction by adding further error such that the total error has a spatial resolution correctable by the apparatus of one or both lithographic processing systems 400a, 400b and or bonding tool 440. In an embodiment, the added error may be divided among a plurality of the relevant apparatuses and or the reticle pattern (e.g., via a reticle modification tool).

The co-optimization may further comprise determining a control recipe for one or both of the first lithographic processing system 400a and lithographic processing system 400b from a first control grid (e.g., measured using a scatterometer and or alignment sensor) associated with the first lithographic processing system 400a and a second control grid (e.g., measured using a scatterometer and or alignment sensor) associated with the second lithographic processing system 400b so as to optimize matching of first control grid and second control grid.

### • Die-to-Wafer Bonding

Die-to-Wafer comprises using a bonding tool to bond a number of individual substrate portions or dies to an acceptor or base substrate (or wafer), e.g., to provide a heterogeneous 3D integration of the individual dies onto the substrate. The dies, for example, may have multiple different data processing and/or storage functionalities and different dimensions.

Figure 5 illustrates the basic concept of die-to-wafer bonding. An acceptor wafer or base patterned wafer (i.e., a second substrate) 500 has been patterned in one or more lithographic steps, and further processed (e.g., etched etc.) in one or more processing steps, as part of an integrated circuit (IC) manufacturing process (e.g., such as illustrated in Figure 1). This patterning and processing may have formed multiple layers onto the wafer as is well known in IC manufacture. Similarly, one or more pre-diced wafers (i.e., one or more first substrates) 510a, 510b are manufactured in a similar manner (although with different patterns/product) as the base patterned wafer 500. In this specific example, two pre-diced wafer types 510a, 510b are produced, each comprising multiple repetitions of a respective different circuit. Pre-diced wafers 5 10a, 510b are then diced to produce individual substrate portions or dies 520a, 520b. These individual dies 520a, 520b are then bonded to the base patterned wafer 500 to produce a die-to-wafer bonded wafer 530 (only a portion of which is shown). The number of individual dies 520a, 520b (and/or number of different types of dies) bonded to the base patterned wafer 500 may vary from shown here. For example, each field and/or die of the base patterned wafer 500 may have bonded thereto one or more dies respectively of one or more different die types. The bonded wafer 530 may undergo additional processing steps (e.g., *inter alia* to fill gaps between the bonded dies) to form a reconstituted wafer. Subsequently additional lithography steps are performed on the reconstituted wafer as has been described.

The bonding of dies to an acceptor wafer with high lateral placement accuracy is crucial to guarantee good electrical contact between the die and acceptor wafer and to meet specifications of tightly controlled parameters of interest such as overlay.

In preparation for bonding, dies may be subject to a thinning step whereby the thickness of the die is reduced e.g. to ~15µm (e.g., by chemical mechanical polishing (CMP)). Said thinning process may cause a die to warp, e.g., owing to residual stresses in the layers that make up the die, causing a magnification, or scaling, error which may lead to an error in a parameter of interest such as overlay. To be bonded dies may be deformed to such an extent that they may cause an intra-die overlay fingerprint that needs to be corrected prior to bonding. The intra-die overlay fingerprint can be broken down into four components: translation, rotation, the afore-mentioned magnification, and residual errors, having for example mean values of 200nm, 20nm, 150nm and 20nm respectively. Said translation, rotation, the aforementioned magnification components may each be considered components of a parameter of interest error.

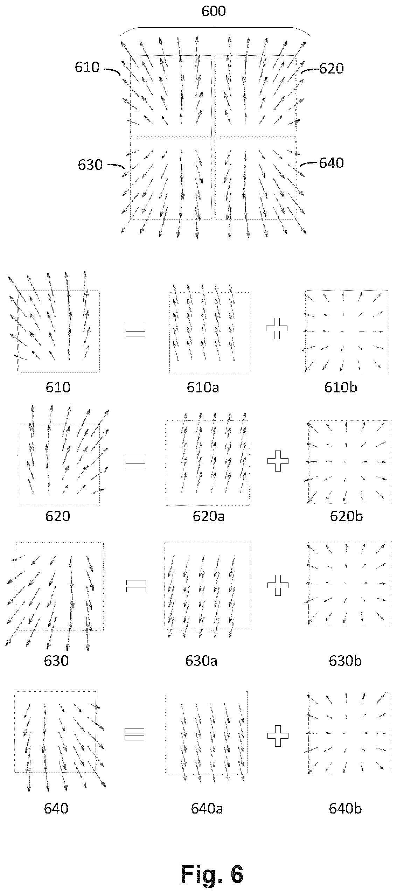

By way of example, Figure 6 depicts overlay vector plots that indicate a displacement of features relative to design coordinates (i.e., causing an alignment or overlay error). Field 600 (i.e., an exposure field) may comprise a plurality of sub-fields 610, 620, 630, 640, e.g., each corresponding to a die. As depicted in e.g., 610a and 610b, the overlay error may comprise a translational component (610a) and a magnification component (610b). Translation errors 610a, 620a, 630a, 640a, may be unique for each die. In contrast, the magnification error 610b, 620b, 630b, 640b, is uniform across the field 600 for each die 610, 620, 630, 640.

Thus, a magnification parameter of interest component or magnification overlay component (i.e., a first component of the parameter of interest data) may be considered as a component of a parameter of interest (e.g., overlay) of a die, said component associated with an overlay error that is uniform across an exposure field of a substrate used in patterning said die.

In contrast, a translation (and/or rotation) overlay error component (i.e., a second component of the parameter of interest data) may be considered as a component of a parameter of interest error of a die, said component associated with an overlay error that is unique in each subfield comprised in an exposure field of a substrate used in patterning said die.

For illustrative purposes, the overlay fingerprint shown in Figure 6 comprises a translation component and a magnification component. It would be apparent to the skilled person that an overlay fingerprint may comprise further overlay components such as rotational or residual as described previously.

A bonding tool which is used for the die-to-wafer bonding (e.g., bonding tool 440 as depicted in Figures 3 and 4) may be configured to correct for translation and rotation components of an overlay error, e.g., by actuation of donor die holders or actuation of a wafer stage during the bonding process. As noted previously, translation and rotation components are die-specific, that is, each die may have a unique translation and/or rotation component associated therewith. In contrast, a magnification component may be uniform across a field (and therefore uniform between each subfield corresponding to an individual die as depicted by magnification error 610b, 620b, 630b and 640b of Figure 6). However, the bonding tool may be incapable of correcting the magnification component of the overlay error. Thus, overlay fingerprint components may be sorted into two categories: components that may be corrected by a bonding tool, such as translational and rotational components, and components that cannot be corrected by a bonding tool, such as magnification.

It is possible to correct for magnification errors (also referred to as a scaling error) using a scanner, stepper or other lithography tool during patterning of a substrate, or wafer (e.g., via lens correction such as by actuating optical components comprised in a lithography tool, for example rigid body movements of a lens element). Further, it is possible to characterize a die-to-wafer bond after bonding in order to determine the magnification fingerprint component, for example using a metrology tool such as bonding metrology tool 450. Additionally, or alternatively, a die that has been subject to processing prior to a bonding process (e.g., a thinning step) may be measured in order to determine a magnification fingerprint component, e.g., using any of metrology tools 450, 410a and/or 410b.

Accordingly, in a first aspect there is provided a method of determining a correction for at least one first substrate and/or a second substrate, the correction the correction being defined across an exposure field on at least one first substrate, wherein the exposure field comprises multiple sub-field portions (e.g., dies), wherein each sub-field portion is to be bonded to a second substrate (e.g., acceptor substrate/wafer) to obtain a bonded substrate in a bonding process. The method comprises obtaining a first component (e.g., a magnification/scaling component) of parameter of interest data relating to a parameter of interest which is common to each one sub-field portion of the said multiple sub-field portions (e.g., bonded substrate overlay data or thinned substrate overlay data); and determining the correction based on suppression of the first component for each sub-field portion of the multiple sub-field portions.

In some cases, during a die-to-wafer bonding process, an interposer layer may be disposed between a die and an acceptor substrate to be bonded (i.e., to facilitate electrical connections between said die and said acceptor substrate). The correction may be applied during exposure of the first substrate (and therefore the at least one first sub-field portion/die) and/or exposure of the interposer.

In some examples, the method may further comprise bonding the at least one first die to an acceptor substrate (second substrate). The step of bonding the at least one first die to the acceptor substrate may further comprise correcting for at least one second component of the parameter of interest. For example, each second component may comprise a translation and/or rotation component which may be unique in each sub-field of the exposure field.

In some examples, the parameter of interest data may describe a spatial distribution of the parameter of interest over an area of the at least one first substrate and/or second substrate.

In some examples, a parameter of a lithographic process of the at least one first die may be modified based on the determined correction, i.e., such that subsequent dies may be fabricated based on said determined correction, in order to "pre-correct" subsequent dies for the determined first component prior to bonding. That is, subsequent dies may be fabricated, e.g., using a lithography tool such as a scanner and/or stepper while taking into account and correcting for the determined magnification component of the overlay error.

In some examples, the correction may be implemented via lens corrections for a projection lens system of the lithographic apparatus. The lens corrections may comprise performing rigid body movements and/or deforming of a lens element (e.g., comprised in the projection optics of a lithographic system configured to perform the lithographic process) in order to impart a modified radiation beam onto a substrate comprising the at least one first die and/or interposer, said modified radiation beam configured to counteract said determined first component of the parameter of interest error.

In other examples not shown, modifying a parameter of the lithographic process may comprise configuring a reticle of a lithographic device based on the determined correction (e.g., during manufacture and/or by thermal actuation), in order to impart a modified radiation beam onto a substrate comprising the at least one first die and/or interposer, said modified radiation beam configured to counteract said determined first component of the parameter of interest error.

Any remaining components of the overlay error such as translational and/or rotational components may be corrected for by a bonding tool (e.g., bonding tool 440) accordingly during a subsequent die-to-wafer bonding process. Thus, there is enabled a die-to-wafer bonding process with a reduced overlay fingerprint.

In some examples, it may be possible to determine a polynomial order of the first component of the parameter of interest error. That is, the magnitude of the first component of the parameter of interest error across a substrate (e.g., a die and/or bonded substrate) may comprise a polynomial distribution. Depending on an order of said polynomial distribution, a specific method of modifying a parameter of the lithographic process may be selected (e.g., rigid body movements of a lens element may be able to correct for magnification errors up to the 2^{nd} or 3^{rd} order, whereas more advanced actuation such as use of adaptive optics (deformation based for example) may allow for up to 12^{th} order magnification error corrections).

Further embodiments of the invention are disclosed in the list of numbered clauses below:
1. A method of determining a correction for at least one first substrate and/or a second substrate, the correction being defined across an exposure field on at least one first substrate, wherein the exposure field comprises multiple sub-field portions, wherein each sub-field portion is to be bonded to a second substrate to obtain a bonded substrate in a bonding process, the method comprising:
   obtaining a first component of parameter of interest data relating to a parameter of interest which is common to each sub-field portion of the said multiple sub-field portions; and
   determining the correction based on suppression of the first component for each sub-field portion of the multiple sub-field portions.
2. The method of clause 1 wherein the first component is a magnification and/or scaling component of the parameter of interest.
3. The method according to any of clauses 1 or 2, further wherein said parameter of interest data comprises metrology data from previously manufactured examples of one or more of said bonded substrates.
4. The method of clause 3, comprising measuring said previously manufactured examples of one or more of said bonded substrates to obtain said parameter of interest data.
5. The method according to any preceding clause, wherein said parameter of interest data comprises metrology data relating to said at least one first substrate or said multiple sub-field portions thereof subsequent to a processing step to reduce the thickness of said at least one first substrate or said multiple sub-field portions thereof.
6. The method of clause 5, further comprising performing the processing step to obtain a thinned at least one first substrate or said multiple sub-field portions thereof.
7. The method according to any preceding clause, wherein said first component and said correction is determined per exposed sub-field portion on the at least one first substrate.
8. The method according to any preceding clause, wherein said correction at least partially comprises lens corrections of a projection lens system of a lithographic apparatus for exposing the at least one first substrate.
9. The method of clause 8, wherein the lens corrections describe rigid body movements of a lens element of the projection lens system and/or actuation of a deformable element of the projection lens system.
10. The method according to any preceding clause, wherein said correction at least partially comprises a reticle correction for a reticle used to expose said at least one first substrate.
11. The method according to any preceding clause, comprising exposing said at least one first substrate and/or an interposer layer for the bonded substrate in accordance with said correction.
12. The method according to any preceding clause, further comprising determining a polynomial order of the first component, wherein the parameter of the lithographic process is modified based on said polynomial order.
13. The method according to any preceding clause, wherein said parameter of interest is overlay.
14. The method according to any preceding clause, wherein each of said multiple sub-field portions is a die.
15. The method according to any preceding clause, wherein said first component of said parameter of interest data is uniform across said exposure field.
16. The method according to any previous clause, further comprising determining a second component of the parameter of interest data; and
   determining a bonding process correction from the second component, for correcting a bonding process of the at least one sub-field portion to the second substrate.
17. The method of clause 16, wherein said bonding correction comprises a correction for a die holder for holding said at least one sub-field portion and/or an acceptor substrate stage for holding said second substrate, of a bonding tool.
18. The method of clause 16 or 17, wherein the second component comprises a rotational and/or translational component of the parameter of interest data.
19. The method according to any of clauses 17 to 18, comprising performing said bonding process to bond said at least one die portion to said second substrate in accordance with said second correction.
20. The method according to any previous clause, wherein the parameter of interest data describes a spatial distribution of the parameter of interest over an area of the at least one first substrate and/or second substrate.
21. A computer program comprising program instructions operable to perform the method according to any of clauses 1 to 20, when run on a suitable apparatus.
22. A non-transient computer program carrier the computer program of clause 21.
23. A processing apparatus comprising: at least one processor; and the non-transient computer program carrier of clause 22.
24. A bonded substrate manufactured according to the method according to any of clauses 1 to 20.
25. A lithographic apparatus being operable to perform the method according to any of clauses 1 to 19.
26. A device manufacturing arrangement for manufacturing die-to-substrate bonded substrates comprising: the lithography apparatus of clause 25; and a bonding apparatus being operable to perform said bonding process to bond said at least one die portion to said second substrate.
27. A device manufacturing arrangement according to clause 26, comprising a metrology apparatus for measuring said parameter of interest data.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of determining a correction for at least one first substrate and/or a second substrate, the correction being defined across an exposure field on at least one first substrate, wherein the exposure field comprises multiple sub-field portions, wherein each sub-field portion is to be bonded to a second substrate to obtain a bonded substrate in a bonding process, the method comprising:
obtaining a first component of parameter of interest data relating to a parameter of interest which is common to each sub-field portion of said multiple sub-field portions; and
determining the correction based on suppression of the first component for each sub-field portion of the multiple sub-field portions.

2. The method of claim 1 wherein the first component is a magnification and/or scaling component of the parameter of interest.

3. The method of claim 1, wherein said parameter of interest data comprises metrology data from previously manufactured examples of one or more of said bonded substrates.

4. The method of claim 1, wherein said parameter of interest data comprises metrology data relating to said at least one first substrate or said multiple sub-field portions thereof subsequent to a processing step to reduce the thickness of said at least one first substrate or said multiple sub-field portions thereof.

5. The method of claim 1, wherein said correction at least partially comprises lens corrections of a projection lens system of a lithographic apparatus for exposing the at least one first substrate.

6. The method of claim 5, wherein the lens corrections describe rigid body movements of a lens element of the projection lens system and/or actuation of a deformable element of the projection lens system.

7. The method of claim 1, wherein said correction at least partially comprises a reticle correction for a reticle used to expose said at least one first substrate.

8. The method of claim 1, further comprising exposing said at least one first substrate and/or an interposer layer for the bonded substrate in accordance with said correction.

9. The method of claim 1, wherein said parameter of interest is overlay.

10. The method of claim 1, wherein each of said multiple sub-field portions is a die.

11. The method of claim 1, wherein said first component of said parameter of interest data is uniform across said exposure field.

12. The method of claim 1, further comprising determining a second component of the parameter of interest data; and
determining a bonding process correction from the second component, for correcting a bonding process of the at least one sub-field portion to the second substrate.

13. The method of claim 12, wherein said bonding correction comprises a correction for a die holder for holding said at least one sub-field portion and/or an acceptor substrate stage for holding said second substrate, of a bonding tool.

14. The method of claim 12 or 13, wherein the second component comprises a rotational and/or translational component of the parameter of interest data.

15. A bonded substrate manufactured according to the method as claimed in claim 1.
